# DEMANDE DE BREVET EUROPEEN

(11) **EP 0 673 894 A2**
(43) Date de publication de la demande: **27.09.1995**
(21) Numéro de dépôt: 95400619.3
(22) Date de dépôt: 21.03.1995
(51) Int. Cl.: C03C 17/245, C03C 17/00

(54) **Procédé et dispositif pour le revêtement d'une plaque de verre munie au moins d'une couche d'oxyde stannique par le procédé de la pulvérisation cathodique réactive**

(30) Priorité: 23.03.1994 DE 4409934
(71) Demandeur: SAINT-GOBAIN VITRAGE, F-92400 Courbevoie (FR)
(72) Inventeur: Schicht, Heinz, Dr., D-06925 Bethau (DE); Ditzel, Gerhard, D-04860 Welsau (DE); Schindler, Herbert, D-04860 Torgau (DE); Schmidt, Uwe, D-04895 Falkenberg/Elster (DE); Kaiser, Wilfried, D-04860 Torgau (DE)
(74) Mandataire: Muller, René

(57) **Abrégé**

L'objet de la présente invention est un procédé de revêtement d'une plaque de verre par une couche multiple semi-réfléchissante, comportant une ou plusieurs couches de SnO₂ et en faisant appel à la pulvérisation cathodique réactive, assistée par l'application d'un champ magnétique en tension continue.

Une cible en étain est utilisée, qui contient de faibles quantités d'additifs constitués de l'un ou de plusieurs des métaux suivants : indium, manganèse, aluminium ou zinc.

L'utilisation de ce matériau permet d'éviter ou au moins de retarder l'apparition de pustules à la surface de la cible d'étain.

## Description

La présente invention concerne un procédé de revêtement d'une plaque de verre par une couche au moins d'oxyde stannique au moyen de la pulvérisation cathodique en tension continue et en utilisant une cible métallique en étain qui renferme une faible quantité d'additif constitué de métal d'alliage. L'invention concerne en outre un dispositif de mise en oeuvre du procédé et une cible en étain utilisable dans cette application.

Les plaques de verre sont en quantités importantes munies de couches fonctionnelles semi-réfléchissantes, qui doivent en général présenter une transmission élevée dans le spectre visible et une forte réflexion dans les radiations infrarouges. Dans cette application, les monocouches d'oxyde stannique et les systèmes multicouches, comportant une couche fonctionnelle métallique, en particulier en argent, et une ou plusieurs couches d'oxyde stannique ont fait leurs preuves. Parmi les systèmes connus de ce type à couches multiples, on distingue par exemple la structure à triple couche verre-SnO₂-Ag-SnO₂, et les structures à quadruple couche verre-SnO₂-Ag-Me-SnO₂, dans lesquelles Me représente une couche protectrice servant à la protection de la couche argentée contre l'effet de l'oxygène lors de la pulvérisation cathodique réactive de la couche protectrice et antireflet en SnO₂, et servant à l'amélioration du comportement à long terme du système multicouches. Les structures à quintuple couche verre-SnO₂-Me-Ag-Me-SnO₂, dans lesquelles une couche métallique protectrice est aussi disposée en-dessous de la couche d'argent, ont également donné de bons résultats.

On sait par le DE 34 13 587 C2 que des perturbations du procédé de dépôt apparaissent au cours de la pulvérisation cathodique réactive de cibles en étain pour la fabrication de la couche de SnO₂ en cas de fonctionnement prolongé de l'installation. De telles perturbations sont par exemple observées à partir d'une durée d'utilisation des cathodes d'environ 50 heures, lorsque l'opération de revêtement est effectuée avec une vitesse de dépôt en pulvérisation élevée de la couche d'oxyde stannique, ce qui est avantageux du point de vue de la rentabilité. Les perturbations se caractérisent par des endommagements localisés des couches sous forme de taches apparaissant sur le substrat revêtu, et dues à des décharges disruptives de la surface de la cible vers les faces de l'anode disposées latéralement.

On suppose que l'origine des décharges disruptives vers les faces latérales de l'anode qui apparaissent lors de ces perturbations est liée à la formation à la longue de couches électriquement isolantes, constituées de dépôts d'oxyde d'étain sur ces faces de l'anode. Ces couches entraînent la naissance locale de courants électriques élevés lors de l'apparition d'une décharge disruptive de la surface de la cible vers les faces de l'anode. Les courants ainsi produits ne peuvent être déchargés de manière satisfaisante vers la couche métallique sous-jacente à travers les dépôts en couches. Cela entraîne que le circuit de protection électronique ne met pas immédiatement la cathode hors circuit, car les valeurs de surintensité ne sont pas atteintes ou ne le sont pas assez vite. Un plasma intensif se forme ainsi localement, qui est à l'origine des endommagements des couches observés sous forme de taches.

Cette perturbation bien connue peut être neutralisée selon le DE 34 13 587 C2, et une durée de fonctionnement supérieure peut par suite être obtenue pour l'opération de déposition, lorsqu'une cible en étain est utilisée qui renferme de faibles quantités d'additif constitué d'un métal appartenant aux groupes Va et Vb du système périodique, et de préférence l'antimoine. Apparemment, on ne dispose d'aucune donnée relative au mode d'action de cet additif métallique.

Il s'est avéré cependant que les difficultés citées plus haut et des perturbations d'un autre type surgissent au cours de l'opération de déposition, et sont à l'origine de la fabrication de produits défectueux, même en cas d'utilisation de cibles en étain, auxquelles sont ajoutés par alliage les métaux des groupes Va et Vb du système périodique. Cela se produit en particulier pour les cathodes à rendement élevé, lorsque celles-ci fonctionnent en régime prolongé avec une charge de plus de 20 kW.

L'objet de l'invention est de perfectionner le procédé du type cité dans le sens d'une plus forte réduction des perturbations apparaissant au cours de l'opération de déposition et des défauts qui leur sont liés, et d'un allongement de la durée d'utilisation de la cathode d'étain, même en cas de densité de puissance élevée de la cible utilisée.

Le problème technique posé est résolu selon l'invention en ce qu'une cible d'étain est utilisée, qui comporte de faibles quantités d'additif constitué d'un ou de plusieurs des métaux suivants : indium, manganèse, aluminium ou zinc.

Préférentiellement, les métaux cités sont alliés à la cible d'étain dans la proportion de 0,01 à 4% en poids.

Des études plus approfondies des corrélations et du mode de fonctionnement de l'invention ont montré qu'apparemment d'autres causes sont à l'origine des perturbations neutralisées par l'invention, différentes de celles des perturbations qui peuvent être éliminées par l'adjonction par alliage des métaux des groupes Va et Vb. En effet, tandis que l'on constate dans le procédé déjà connu que des dépôts non conducteurs sur les plaques métalliques de l'anode et les parois de l'enceinte de dépôt entraînent les perturbations, sur lesquelles les métaux d'alliage des groupes Va et Vb exercent un effet favorable, il est possible d'éviter selon l'invention des modifications perturbatrices agissant sur la cible elle-même. Car, outre les dépôts d'oxyde d'étain jouant le rôle d'isolant électrique sur les composants anodiques de l'enceinte de dépôt, il est bien connu que des dépôts en forme de pustules se forment à la surface de la cible, abaissent la vitesse de pulvérisation et exercent un effet défavorable sur la stabilité du procédé de dépôt. Ces dépôts en forme de points ou de pustules commencent à se former sur la cible après environ 1000 kWh de fonctionnement. Avec l'accroissement de ce dernier, la formation de pustules se renforce et couvre peu à peu la totalité de la surface de la cible. Le phénomène, qui semble constituer également la cause essentielle des perturbations observées, n'est pas neutralisé par l'addition de métaux des groupes Va et Vb, mais, de manière inattendue, par l'adjonction par alliage de petites quantités des métaux selon l'invention, ou il est au moins considérablement ralentie.

Des analyses chimiques précises de la surface de la cible ont établi que les aspérités pustuleuses couvrant cette dernière se composent de dépôts en couches d'oxydes d'étain de composition chimique Sn0₂ et Sn₅O₆. Les zones intactes de la surface de la cible sont par contre recouvertes d'une mince couche de SnO. Cela laisse supposer que la croissance en couches des aspérités pustuleuses est causée par un processus de redéposition, qui est lié à la composition chimique de la surface de la cible. De toute évidence, il existe sur cette surface des emplacements qui agissent comme des centres de germination pour la formation de ces pustules et qui exercent aussi un effet de catalyseur sur le degré d'oxydation des dépôts.

C'est à ce stade que semble entrer en jeu l'action des métaux d'alliage selon l'invention. Chez ces derniers, il s'agit en effet sans exception de métaux dont l'énergie libre de formation par rapport à l'oxygène est > 61 kcal/atome-gramme. Ces éléments ajoutés par alliage ont apparemment un effet déterminant, direct ou indirect, sur le degré d'oxydation des oxydes d'étain et sur la formation des pustules à la surface de la cible. Il semble qu'il se forme en même temps des phases oxydées des éléments d'alliage, qui bloquent par effet de catalyse la formation de SnO₂ et de Sn₅O₆ et la croissance des ces phases oxydées sous la forme perturbatrice citée plus haut.

Le procédé selon l'invention sera illustré plus précisément au moyen de quelques exemples, les résultats de divers exemples réalisés selon l'invention étant mis en parallèle avec ceux d'un exemple comparatif.

### Exemple comparatif

Dans une installation de pulvérisation magnétron d'essais, les principaux paramètres de dépôt ont été approximativement adaptés à ceux d'une installation industrielle et réglés comme suit :

| | |
|---|---|
| Puissance du magnétron : | 2,4 kW |
| Dimensions de la surface de la cible : | 30 x 15 cm² |
| Pression totale : | 4 à 5 x 10⁻³ mbar |
| Pression partielle de l'argon : | 2 x 10⁻³ mbar |
| Flux d'argon : | 13 à 15 cm³/S |
| Flux d'oxygène : | 20 à 40 cm³/S |
| Tension de pulvérisation : | 260 à 325 V |
| Courant de pulvérisation : | 7,5 à 9,5 A |

Dans ces conditions opérationnelles du procédé, une cible d'étain de degré de pureté 99,9 % en poids a été utilisée, renfermant les impuretés suivantes : 27 ppm de Bi, 239 ppm de Pb, 119 ppm de Sb, 33 ppm d'In, 11 ppm de Fe, 16 ppm d'As. La durée de fonctionnement était de 76 heures et la profondeur correspondante de la zone d'érosion, 5,5 mm.

Au cours de la durée de fonctionnement, des décharges disruptives dues à l'arc se sont souvent produites. A la fin de l'opération, la surface de la cible était couverte de foyers étendus de pustules en bordure de la zone d'érosion et à l'intérieur de celle-ci.

### Exemples selon l'invention

Dans le cas des exemples de réalisation, quatre cibles différentes ont été testées dans les mêmes conditions opérationnelles que celles de l'exemple comparatif. Le matériau initial des cibles était dans tous les cas de l'étain à degré de pureté de 99,99 % en poids. Les métaux suivants ont été ajoutés dans les proportions suivantes à cet étain pur :

| | |
|---|---|
| Exemple 1 : | 0,13% d'indium en poids |
| Exemple 2 : | 0,046 % de manganèse en poids |
| Exemple 3 : | 0,10% d'aluminium en poids |
| Exemple 4 : | 0,082% de zinc en poids |

Ces quatre cibles ont été examinées pour rechercher la présence de pustules après les durées d'utilisation suivantes :

| | |
|---|---|
| Exemple 1 (Sn/In) : | 54,5 heures |
| Exemple 2 (Sn/Mn) : | 55 heures |
| Exemple 3 (Sn/Al) : | 76 heures |
| Exemple 4 (Sn/Zn) : | 55 heures |

Il a ainsi été établi qu'aucune formation de pustules n'a été décelée pour les cibles des exemples 1 à 3. Des pustules isolées ont été découvertes uniquement pour la cible de l'exemple 4, mais leur nombre et leurs dimensions ne sont cependant pas en rapport avec les cibles étudiées selon l'état actuel de la technique.

## Revendications

1. Procédé de revêtement d'une plaque de verre avec au moins une couche d'oxyde stannique au moyen de la pulvérisation cathodique réactive assistée par l'application d'un champ magnétique en tension continue et avec utilisation d'une cible en étain, renfermant une faible quantité d'un métal d'alliage, **caractérisé en ce que** la cible en étain contient une faible quantité d'un ou de plusieurs métaux, dont l'indium, le manganèse, l'aluminium ou le zinc.

2. Procédé selon la revendication 1, **caractérisé en ce que** l'addition du métal d'alliage s'effectue dans la proportion de 0,01 à 4% en poids, et de manière préférentielle, dans la proportion de 0,02 à 1% en poids.

3. Dispositif de mise en oeuvre du procédé selon la revendication 1 ou la revendication 2, avec une installation comportant une cible en étain pour la pulvérisation cathodique réactive assistée par l'application d'un champ magnétique, **caractérisé** par une cible en étain, contenant une faible quantité d'additif constitué de l'un ou de plusieurs des métaux suivants : indium, manganèse, aluminium ou zinc.

4. Dispositif selon la revendication 3, **caractérisé en ce que** l'addition du métal d'alliage s'effectue dans la proportion de 0,01 à 4% en poids.

5. Cible en étain pour l'utilisation d'une installation de pulvérisation cathodique en tension continue assistée par l'application d'un champ magnétique, **caractérisée** par l'addition d'une faible quantité de l'un ou de plusieurs des métaux suivants : indium, manganèse, aluminium ou zinc.
